Europäisches Patentamt

European Patent Office

Office européen des brevets

(19)

(11) Veröffentlichungsnummer: **0 130 312**
A2

(12) # EUROPÄISCHE PATENTANMELDUNG

(21) Anmeldenummer: 84105137.8

(22) Anmeldetag: 08.05.84

(51) Int. Cl.⁴: **B 32 B 31/08,** B 32 B 31/12, B 32 B 15/08

(30) Priorität: 05.07.83 CH 3676/83

(43) Veröffentlichungstag der Anmeldung: 09.01.85 Patentblatt 85/2

(84) Benannte Vertragsstaaten: **AT BE DE FR GB IT LU NL SE**

(71) Anmelder: **Sinter Limited, 15 Pembroke Road, Bristol BS99 7DX (GB)**

(72) Erfinder: **Caratsch, Hans-Peter, Itenhardstrasse 16, Bremgarten AG (CH)**

(74) Vertreter: **Eitle, Werner, Dipl.-Ing. et al, Hoffmann, Eitle & Partner Patentanwälte Arabellastrasse 4, D-8000 München 81 (DE)**

(54) **Kontinuierliches Verfahren zur Herstellung metallkaschierter Schichtpressstoffe.**

(57) Kunstharzimprägnierte Flächengebilde (2) werden in einer kontinuierlich arbeitenden Laminatpresse (14) unter Wärme zu einem Schichtpreßstoff (16) verpreßt. Letzterer wird von einem Revers Roll Coater (18, 18') mit einem härtbaren Harz versehen. Auf den harzbeschichteten Schichtpreßstoff (16') wird eine warme Metallfolie (24, 24') aufgebracht und die Harzschicht wird im nachfolgenden Ofen (26) ausgehärtet.

Der erhaltene metallbeschichtete Schichtpreßstoff (28) weist eine glatte gleichmäßige Oberfläche auf.

EP 0 130 312 A2

ACTORUM AG

Kontinuierliches Verfahren zur Herstellung metallkaschierter Schichtpressstoffe

Die Erfindung betrifft ein kontinuierliches Verfahren
zur Herstellung von metallkaschierten Schichtpressstoffen,
insbesondere von Elektrolaminaten, gemäss dem Oberbegriff
des Anspruches 1.

Elektrolaminate werden im allgemeinen im diskontinuierlichen Verfahren hergestellt. Dabei wird das Flächengebilde, z.B. Glasfasergewebe, mit dem härtbaren Harz imprägniert und das Harz bis zum sogenannten B-Zustand, der eine
Lagerung erlaubt und trotzdem noch beim Verpressen zum
Schichtpressstoff eine Aktivierung gestattet, vorgehärtet.
Das erhaltene sogenannte Prepreg wird dann in Stücke bestimmter Länge geschnitten oder aufgerollt und erst vor
dem Verpressen geschnitten. Die als Metallfolie für
Elektrolaminate verwendete Kupferfolie wird auf die gleiche Länge wie die Prepregs geschnitten und mit letzteren zu einem sogenannten Presspaket zusammengestellt, das in einer Etagenpresse verpresst und ausgehärtet wird. Dieses diskontinuierliche
Verfahren ist nicht nur sehr zeitraubend und personalintensiv, sondern hat auch technische Nachteile, da beim
Schneiden des vorgehärteten Flächengebildes viel Staub
entsteht. Ausserdem wird mit sehr dünnen Kupferfolien
die für Elektrolaminate geforderte Qualität kaum erreicht,
so dass kostspielige Hilfskonstruktionen, wie eine zusätzliche dickere Tragfolie aus Kupfer, verwendet werden
müssen.

Man hat deshalb seit Jahren versucht, weniger zeit- und personalaufwendige, d.h. kontinuierliche, Verfahren zur Herstellung von Elektrolaminaten zu entwickeln. So ist z.B. aus der DE-PS 1 216 522 ein kontinuierliches Verfahren bekannt, bei dem alle am fertigen Produkt beteiligten Schichten, d.h. Prepregs und Metallfolien, übereinander gelegt, zur Vorhärtung des wärmehärtbaren Harzes erwärmt und unter einem fortschreitenden örtlichen Druck und Wärmeeinwirkung zu einem einstückigen Produkt ausgehärtet werden. Dieses Verfahren liefert schnell und mit wenig Personal einen staubfreien metallbeschichteten Schichtpressstoff, der jedoch in qualitativer Hinsicht nicht zu befriedigen vermag. Die Oberflächen dieses Schichtpressstoffes, d.h. die Metallfolien, sind unregelmässig, insbesondere zeigen sich in Längsrichtung erstreckende Rillen und Falten. Ausserdem bewirken kleinste, im Betrieb nicht vermeidbare,Unregelmässigkeiten des Förderbandes, eine Beschädigung der Metalloberfläche. Solche Schichtpressstoffe können von der Elektronikindustrie, die sie zu gedruckten Schaltungen verarbeitet, nicht akzeptiert werden, da für den genannten Zweck eine einwandfreie glatte Oberfläche und durchgehende gleichmässige Haftung der Schichten unerlässlich ist. Weiterhin wird von dieser Industrie die Verwendung immer dünnerer Kupferfolien verlangt, was konkret bedeutet, dass Folien einer Dicke von 35 bis 20 μ durch solche von bis zu 2 μ ersetzt werden müssen.

Aufgabe der vorliegenden Erfindung ist es deshalb, ein kontinuierliches Verfahren der eingangs genannten Art zur Herstellung von metallkaschierten Schichtpressstoffen zu schaffen, das einen Schichtpressstoff mit qualitativ einwandfreier gleichmässiger glatter Oberfläche liefert.

0130312

Diese Aufgabe wird erfindungsgemäss durch die Merkmale des kennzeichnenden Teils von Anspruch 1 gelöst.

Die erfindungsgemässe Auftrennung des bisher einschrittigen Vorganges in zwei aufeinderfolgende Schritte, nämlich in das Allein-miteinander-Verbinden der Schichten des Schichtpressstoffes zu einem inerten Kernstück und das nachfolgende getrennte Verbinden des erhaltenen nicht haftfähigen und nicht aktivierbaren Kerns mit der vorgewärmten Metallfolie, erlaubt die kontinuierliche Herstellung qualitativ einwandfreier und gleichmässiger metallkaschierter Schichtpressstoffe, insbesondere von Elektrolaminaten, auch mit dünnen Metallfolien.

Entgegen den aus dem obengenannten Stand der Technik zur Verbesserung der Oberflächenbeschaffenheit, bei der kontinuierlichen Herstellung von Elektrolaminaten, bekannten Bestrebungen zur Konzentration wird erfindungsgemäss die Herstellung auf mehrere getrennte, aufeinanderfolgende Schritte aufgeteilt, d.h. das Verfahren nicht konzentriert, sondern gedehnt.

Da anstelle des einen aktiven Systems - ein Harz - erfindungsgemäss zwei getrennte aktive Systeme - zwei Harze - von denen jedes zu einem anderen Zeitpunkt aktiv ist, verwendet werden, unterscheidet sich das erhaltene Produkt auch bezüglich seiner Bausteine vom Produkt des bekannten Verfahrens. Letzteres ist ein einstückiges Gebilde, in dem die Verbindung der einzelnen Schichten, d.h. der Prepregs, miteinander und der Metallfolie mit dem gleichen Mittel, unter gleichen Bedingungen und gleichzeitig erfolgt. Diese Gleichheitszeichen werden erfindungsgemäss aufgehoben. Durch Aufhebung der Gleichheitszeichen verschwindet die von ihnen bewirkte Einstückigkeit des metallkaschierten Schichtpressstoffes. Sie wird durch die getrennten Elemente oder Bausteine eines nicht-klebenden inerten Kerns (dargestellt durch die in einem eigenen Arbeitsgang miteinander verpressten und gehärteten Prepregs), einer Harzschicht und einer Metallfolie ersetzt. Daraus resultieren anstelle der bisherigen einzigen heterogenen Verbindung Prepreg/Metallfolie die zwei neuen heterogenen Verbindungen inerter Kern/Harz und Harz/Metallfolie, d.h. ein auf den ersten Blick komplizierteres und anfälligeres Bausystem.

Es wird vermutet, dass die unerwartet gute Haftung und glatte einwandfreie Oberfläche der Metallfolie im erfindungsgemäss hergestellten Schichtpressstoff gerade durch Nichtbefolgung und sogar Widerhandlung gegen die etablierten Regeln der Elektrolaminatherstellung erzielt wird.

Die erfindungsgemässe Alleinaushärtung, d.h. Alleinschrumpfung des Kerns, verhindert die Entstehung eines Uebermasses der Metallfolie, das ausser für die Faltenbildung auch für die Abdrücke des Förderbandes verantwortlich ist. Beim Abkühlen des erfindungsgemäss erhaltenen Produktes kann die durch die Alleinerwärmung bewirkte Wärmedehnung der nun mit dem Schichtpressstoff verbundenen Metallfolie, infolge der unterschiedlichen Wärmedehnungskoeffizienten von Kern und Metall, nur teilweise rückgängig gemacht werden. Die Metallfolie bleibt deshalb in der Art einer Schrumpffolie auf dem Kern aufgespannt, d.h. sie bildet eine faltenfreie Haut auf der Unterlage. Dabei entsteht die gleiche Wirkung wie wenn bei konstanter Folienfläche der Kern ausgedehnt und dadurch die Folie aufgespannt wird.

0130312

Faltenbildung durch das Schrumpfen der Schicht des zweiten Harzes bei dessen Aushärtung wird nicht beobachtet. Dies hat vermutlich zwei miteinander zusammenwirkende Gründe. Die Dimensionsänderung der dünnen Harzschicht wird am bereits gehärteten, unveränderlichen Kern durch Adhäsion, die auf die Schrumpfbewegung eine Art Bremswirkung ausübt, gehemmt und die Aushärtung schreitet in an dem noch warmen Kern und die warme Metallfolie angrenzenden Randbereichen schneller fort, so dass aus dem mittleren noch plastischen Bereich der Schrumpfungsverlust durch nachfliessendes Material ausgeglichen werden kann. Das über den Querschnitt der Harzschicht von aussen nach innen gestaffelte Einsetzen der Aushärtung sowie das Festhalten der Folie unter Spannung mag auch für die gute Haftung der Metallfolie trotz druckfreiem Schlusshärteschritt verantwortlich sein.

Die Schrumpffolienwirkung erlaubt die erfindungsgemässe Verwendung sehr dünner Metallfolien. Zusätzlich gestattet die über eine längere Strecke vom Kern getrennte Führung der Metallfolie deren schonendere Handhabung. Die Zwischenschicht des zweiten wärmehärtbaren Harzes wirkt ausserdem als Polster, das etwaige Unebenheiten des Schichtpressstoffes ausgleicht. Das getrennte Aufbringen der Metallfolie gestattet die Verwendung polierter Kaschierwalzen, anstelle der Förderbänder beim bekannten Verfahren, so dass eine zusätzliche Verbesserung der Oberflächenbeschaffenheit der erfindungsgemäss hergestellten metallkaschierten Schichtpressstoffe erzielt wird.

Bevorzugte Ausführungsformen des erfindungsgemässen Verfahrens sowie eine Vorrichtung zur Durchführung des Verfahrens bilden den Gegenstand der Ansprüche 2 bis 17.

Als Materialien für das Flächengebilde kommen sowohl anorganische als auch organische Materialien, wie Asbest, Glasfaser, Cellulose und Kunstfaser in Form von Geweben, Vliessen, Papier oder Karton, in Frage.

Als erstes härtbares, vorzugsweise wärmehärtbares, Harz kann ein bekanntes Harz,das bereits für die Herstellung von Schichtpressstoffen verwendet wurde, eingesetzt werden. Beispiele für solche Harze sind Phenol-Formaldehyd-, Kresol-Formaldehyd-, Melamin-Formaldehyd-, Epoxid- und ungesättigte Polyesterharze. Ihre Eigenschaften können mit entsprechenden Zusatzstoffen, z.B. Beschleunigern, für die Bedürfnisse des erfindungsgemässen Verfahrens eingestellt werden.

Als zweites härtbares Harz kann ein Harz vom gleichen Typ, gegebenenfalls zusammen mit weiteren mitreagierenden Komponenten und/oder Zusatzstoffen zur Einstellung der Topfzeit der Aushärtungsgeschwindigkeit und anderen Eigenschaften, eingesetzt werden.

Folien verschiedener Metalle bis zu einer sehr dünnen Qualität, z.B. 2 µ, können erfindungsgemäss verwendet werden. Für Elektrolaminate, die zur Herstellung von gedruckten Schaltungen eingesetzt werden, kommt in erster Linie Kupfer in Frage. Die mit dem Schichtpressstoff zu verbindende Fläche der Metallfolie kann vor dem Kaschieren einer Behandlung, wie Corona-Entladung, chemisches Aetzen oder mechanisches Aufrauhen, zur Verbesserung der Haftfähigkeit der Metallfolie am zweiten Harz und dadurch der Bindung am Schichtpressstoff,unterworfen werden.

Nachfolgend wird ein Ausführungsbeispiel der Erfindung anhand einer Figur veranschaulicht, die eine schematische Darstellung einer Vorrichtung zur Durchführung des erfindungsgemässen Verfahrens zeigt.

Sechs mit einem härtbaren Harz imprägnierte und getrocknete Bahnen 2 von Glasseidengewebe werden von einem Einzugswerk 8 von sechs Vorratsrollen 4 über je eine Umlenkrolle 6 abgezogen und zu einem sechsschichtigen Gebilde 10 vereinigt. Dieses Gebilde 10 gelangt vom Einzugswerk 8 zu einem Vorwärmofen 12 und danach in eine kontinuierlich arbeitende Hochdruck-Laminatpresse 14, die es als bis Null-Harzfluss gehärteter, d.h. durch Druckeinwirkung nicht mehr verformbarer und durch Wärme nicht aktivierbarer, Schichtpressstoff 16 verlässt. Der Schichtpressstoff 16 wird dann mit je einem ober- und unterhalb der Transportstrecke angeordneten Reverse Roll Coater 18,18' mit einem zweiten wärmehärtbaren Harz beschichtet. Die Reverse Roll Coater 18,18' können beheizt werden, was die Einleitung der Härtung des zweiten härtbaren Harzes schon an dieser Stelle erlaubt. Der beidseitig eine klebrige Harzschicht aufweisende Schichtpressstoff 16' gelangt dann zwischen zwei beheizte polierte Kaschierwalzen 20,20' eines beheizten Kaschierwerkes 22, wo er mit zwei heissen Kupferfolien 24,24' beschichtet wird. Im nachfolgenden Aushärteofen 26 findet die vollständige Aushärtung des zweiten härtbaren Harzes und damit die dauerhafte Verbindung zwischen Schichtpressstoff 16 und Kupferfolien 24,24' statt. Der metallkaschierte Schichtpressstoff 28 wird dann an den Rändern beschnitten und z.B. mit einem Guillotine-Querschneider in Platten gewünschter Länge geschnitten. Die Platten können dann für den Weitertransport und für die Lagerung gestappelt werden.

Die nach diesem wirtschaftlich vorteilhaften Verfahren erhaltenen Elektrolaminate sind von gleichmässiger einwandfreier Qualität und genügen den hohen Anforderungen der Elektronikindustrie.

Selbstverständlich können mehr oder weniger als sechs Bahnen eines Flächengebildes eingesetzt werden.

Das Aufbringen des zweiten Harzes kann unmittelbar vor dem Kaschierwerk auf den Schichtpressstoff oder auf die Metallfolie erfolgen. Ausserdem können hinter dem Kaschierwerk weitere beheizte Anpressrollen angeordnet sein.

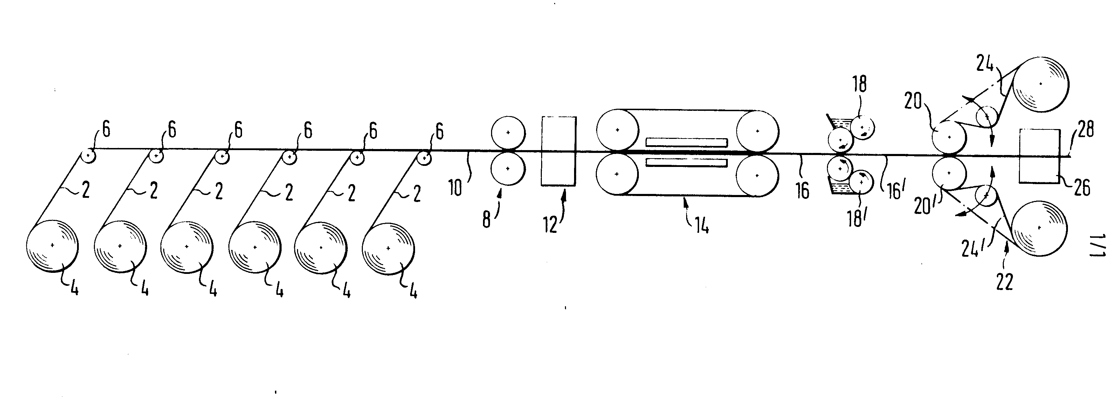

## Patentansprüche

1. Kontinuierliches Verfahren zur Herstellung von metallkaschierten Schichtpressstoffen, insbesondere Elektrolaminaten, durch Verbinden von mit einem härtbaren Harz versehenen Flächengebilden und einer Metallfolie unter Druck und Wärme, dadurch gekennzeichnet, dass man in einem ersten Schritt die mit einem ersten härtbaren Harz versehenen Flächengebilde unter Druck und Wärme zu einem Schichtpressstoff und in einem zweiten Schritt die erwärmte Metallfolie mittels eines zweiten härtbaren Harzes unter Druck und Wärme mit dem Schichtpressstoff verbindet.

2. Verfahren nach Anspruch 1, dadurch gekennzeichnet, dass man den Schichtpressstoff beidseitig mit einer Metallfolie verbindet.

3. Verfahren nach Anspruch 1 oder 2, dadurch gekennzeichnet, dass man ein wärmehärtbares Harz verwendet.

4. Verfahren nach einem der vorangehenden Ansprüche, dadurch gekennzeichnet, dass man als erstes und zweites härtbares Harz das gleiche Harz verwendet.

5. Verfahren nach einem der vorangehenden Ansprüche, dadurch gekennzeichnet, dass man im ersten Schritt den Schichtpressstoff bis zum Null-Harzfluss aushärtet.

6. Verfahren nach einem der vorangehenden Ansprüche, dadurch gekennzeichnet, dass man das zweite härtbare Harz auf den Schichtpressstoff aufbringt.

7. Verfahren nach einem der vorangehenden Ansprüche, dadurch gekennzeichnet, dass man das zweite härtbare Harz auf die Metallfolie aufbringt.

8. Verfahren nach einem der vorangehenden Ansprüche, dadurch gekennzeichnet, dass man den Härtevorgang des zweiten härtbaren Harzes vor dem Aufbringen der Metallfolie auf den Schichtpressstoff einleitet.

9. Verfahren nach einem der vorangehenden Ansprüche, dadurch gekennzeichnet, dass man eine Fläche der Metallfolie einer die Haftfähigkeit verbessernden Vorbehandlung unterwirft.

10. Verfahren nach einem der vorangehenden Ansprüche, dadurch gekennzeichnet, dass man die Metallfolie auf den noch heissen Schichtpressstoff aufbringt.

11. Verfahren nach einem der vorangehenden Ansprüche, dadurch gekennzeichnet, dass man die Metallfolie mit einer beheizten polierten Walze auf den Schichtpressstoff aufbringt.

12. Verfahren nach einem der vorangehenden Ansprüche, dadurch gekennzeichnet, dass man als Metallfolie eine Kupferfolie verwendet.

13. Vorrichtung zur Herstellung eines metallkaschierten Schichtpressstoffes mit einer kontinuierlich arbeitenden Laminatpresse, gekennzeichnet durch ein nach der Laminatpresse (14) angeordnetes heizbares Kaschierwerk (22) und eine Einrichtung (18,18') zum Aufbringen einer flüssigen oder pastösen Zubereitung, wobei sowohl Kaschierwerk (22) als auch Einrichtung (18,18') in Durchlaufrichtung nach der Laminatpresse (14) angeordnet sind.

14. Vorrichtung nach Anspruch 13, dadurch gekennzeichnet, dass das Kaschierwerk (22) polierte Walzen (20,20') aufweist.

15. Vorrichtung nach Anspruch 13 oder 14, dadurch gekennzeichnet, dass die Einrichtung (18,18') zum Aufbringen einer flüssigen oder pastösen Zubereitung zwischen Laminatpresse (14) und Kaschierwerk (22) angeordnet ist.

16. Vorrichtung nach Anspruch 13 oder 14, dadurch gekennzeichnet, dass die Einrichtung (18,18') zum Aufbringen flüssiger oder pastöser Zubereitungen dem Kaschierwerk (22) zugeordnet ist.

17. Vorrichtung nach einem der vorangehenden Ansprüche, dadurch gekennzeichnet, dass sie in Durchlaufrichtung nach dem Kaschierwerk einen Aushärteofen (26) aufweist.

6　6　6　6　6　6

2　2　2　2　2　2

4　4　4　4　4　4

10

8

12

14

16　16'

18

18'

20

20'

24

24'

22

26

28

1/1

0130312